Europäisches Patentamt

European Patent Office

Office européen des brevets

(19)

(11) Publication number: **0 251 910**
**A2**

(12) **EUROPEAN PATENT APPLICATION**

(21) Application number: **87401475.6**

(22) Date of filing: **25.06.87**

(51) Int. Cl.⁴: **H 03 K 19/00**
**H 03 K 19/094**

(30) Priority: **25.06.86 JP 149023/86**

(43) Date of publication of application:
**07.01.88 Bulletin 88/01**

(84) Designated Contracting States: **DE FR GB**

(71) Applicant: **FUJITSU LIMITED**
**1015, Kamikodanaka Nakahara-ku**
**Kawasaki-shi Kanagawa 211 (JP)**

(72) Inventor: **Naganuma, Masayuki Fujitsu**
**Kamikodanakaryo**
**913, Kamikodanaka Nakahara-ku**
**Kawasaki-shi Kanagawa 211 (JP)**

(74) Representative: **Joly, Jean-Jacques et al**
**CABINET BEAU DE LOMENIE 55, rue d'Amsterdam**
**F-75008 Paris (FR)**

(54) **CMOS output buffer circuit.**

(57) A time constant circuit (61, 62) is inserted in at least one of the gate circuits of the p and n channel FETs (71, 72) of the CMOS output buffer circuit. The time constant circuit slightly slows down the voltage variation of signals input to the gates, whereby the rush current running through the output FETs for charging up or discharging the load capacitance is decreased, resulting in a reduction of the noise function of the time derivative dI/dt of the current, without much affecting the total switching time of the output circuit. Due to the difference of time lags between the build up and trailing edges of input pulses for both output FETs, one of the output FETs becomes conductive always after the other one is cut off. Therefore, the excess current is reduced. The time constant circuit may be formed of a resistor and an inverter circuit, serially connected between positive and negative voltage sources. A time constant circuit may be provided in both or one of the driving circuits for the output FETs.

**FIG. 2**

EP 0 251 910 A2

Description

The present invention relates to a complementary metal oxide semiconductor (CMOS) type output buffer circuit for driving a high current load.

Recently as the integration of circuitries in IC (integrated circuit) increases, the logic circuits of the IC are designed to be operated by as small power as possible, while the loads driven by the IC are unchanged or the IC has an increased capacity, being designed to drive many loads at a same time. Therefore, the buffer circuits provided in the IC are becoming large and of increasing number to drive such loads. But, as the output of the buffer circuit becomes large and its switching speed is increased, a problem occurs which is caused by the switching noise of the output buffer circuits. Namely, quick change of a large current in the output buffer circuit induces a noise, and causes defects in the operation in the inner logic circuits of the IC. Such trend is especially becoming severe in large scale integrated circuits (LSI), in which the chance increases that many of the output buffer circuits are operated at a same time and cause the noise to increase.

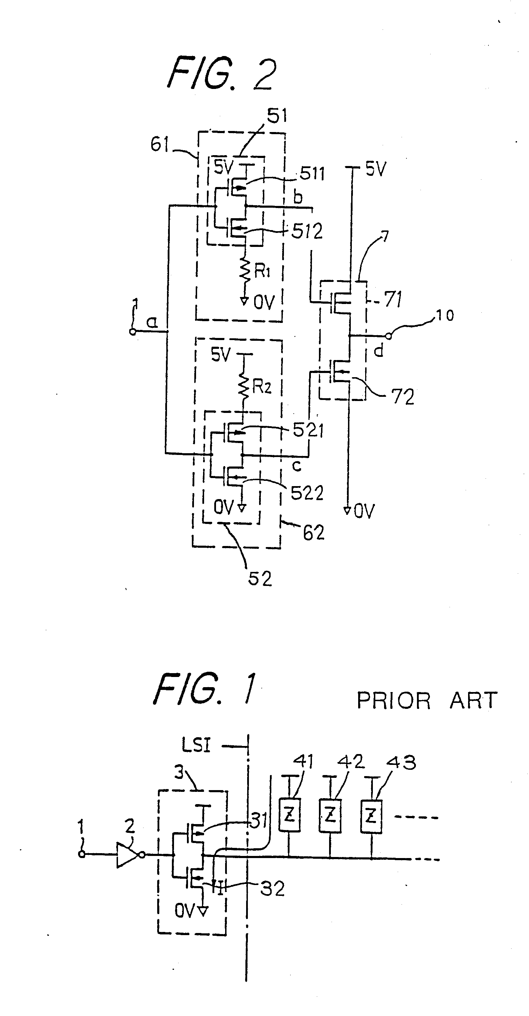

A circuit diagram of a prior art output buffer circuit used in many ICs is shown in Fig. 1. A vertical chained line represents the border between the inside of the IC (such as a LSI), which may be considered as an IC chip or package (on the left hand side), and the outside of the IC (on the right hand side). The output signal of the inner circuit (not shown) of the IC appears at a circuit point 1, which is an input terminal for the output circuit. In this example, the output circuit is composed of two inverter stages 2, 3, the first one being a small size inverter which operates as a driver circuit, and the second one being a larger inverter composed of series connected p and n channel FETs (field effect transistors) 31 and 32 respectively. The gates of the FETs 31, 32 are connected in common and receive the output of the first inverter 2. The drains of the FETs 31 and 32 are connected to each other and provide the output. 41, 42 and 43.... are loads driven by the output circuit 3. In this example, they are connected in parallel.

In ordinary ICs, the FETs 31 and 32 are designed to have a large current handling capacity to provide enough current for driving the loads. Accordingly, the ratio W/L of the gate width (W) to the gate length (L) of the FETs is designed to be larger in order to reduce the internal resistance so as to provide a large current. But in such prior art circuits, noise is produced when the load is driven ON and OFF in response to quick changes of the driving current I running through the output buffer circuit. As mentioned before, this problem is further emphasized in LSIs due to the increased probability of having many of such large output currents from many output circuits switched ON and OFF at the same time.

In an attempt to overcome such a problem, it has been proposed to reduce the noise by decreasing the time derivative dI/dt of the current in the output buffer circuit. To this effect, the wave form of the input signal to the output buffer circuit is slightly blunted. By such blunting, the overall switching speed of the output circuit is not affected substantially, because most of the switching speed of the output circuit is determined by the saturation current of the output buffer circuit, and only the noise is reduced. More details are disclosed in, for example, Japanese Laid Open Patent 60-136238 (published on July 17, 1985) by S. Fujii et al, and in the European Patent Appln. No. 84308891.5.

By the method proposed by Fujii et al, the noise of the output buffer circuit has been suppressed cleverly, but another problem remains, lying in the excess current which instantaneously runs through the output buffer circuit when the inverter circuit is switched from ON to OFF or vice versa. There is a time interval during which both of the series connected p and n channel FETs in the output buffer circuit become conductive, whereby an excess current runs from the positive voltage source through the CMOS circuit to the negative voltage source, this excess current increasing when the internal resistance of the FETs of the output buffer circuit is reduced. Such excess current is undesirable for the IC because it increases the loss of the circuit and causes temperature rise of the IC chip. It also induces noise because such excess current forms a sharp pulse. Such phenomena are known in the art, and several proposals have been made to avoid such an excess current. For example, U.S. Patent No. 4 164 842 by Ebihara discloses a method consisting in the insertion of a delay circuit in the input side of the p and n channel output FETs for slightly shifting the input pulses from each other when they reach the gates of the output FETs, so as to eliminate the time interval during which both of the series connected p and n channel FETs become conductive at the same time.

But no method has been proposed to avoid in a simple way both the noise and the excess current.

The object of the invention, therefore, is to provide an output buffer circuit having a large current handling capacity and wherein the noise and the excess current are suppressed.

Another object of the invention is to attain the above object in a simple manner.

The output buffer circuit according to the present invention comprises :

an input terminal for receiving an input signal ;

a first voltage source for providing a first voltage ;

a second voltage source for providing a second voltage ;

a p channel output field effect transistor (FET) having a gate ;

an n channel output FET having a gate, the p channel output FET and the n channel output FET being serially connected between the first and second voltage sources ; and

at least a first time constant circuit, connected between the input terminal and one of the gates of the p and n channel output FETs, for slowing down the voltage rise up or falling down of a signal appearing at said one of the gates of the p and n channel output FETs in response to the input signal ;

the other one of the gates of the p and n channel output FETs being operatively connected to the input terminal.

A second time constant circuit may be connected between the input terminal and the other one of the gates of the p and n channel output FETs.

The time constant circuit slows down the current variation of the input pulse to the CMOS circuit, whereby dl/dt is decreased and hence the noise is decreased. At the same time, the building up and trailing edges of the input pulses for each of the output FETs are shifted from each other ; the time interval during which both of the p and n channel transistors become conductive at the same time is thereby avoided, and the excess current is suppressed.

By the insertion of the time constant circuits, the input pulse for the p and n channel FETs are automatically shifted from each other. Thus, the object of reducing noise and excess current is attained in a simple way. Further, only one time constant circuit for one of the FETs may be provided, resulting in a very simple circuit.

These and other features and advantages of the invention will become more readily apparent from a reading of the following description made, by way of illustration, but not restrictively, in connection with the accompanying drawings wherein :

- Fig. 1 shows a CMOS output buffer circuit according to the prior art ;

- Fig. 2 is a circuit diagram of a first embodiment of the circuit according to the present invention which comprises a time constant circuit in each one of the two gate circuits of the output CMOS circuit ;

- Fig. 3A shows waveforms illustrating the variation of voltage with respect to time in various points of the circuit of Fig. 1 when the input voltage is pulled down from high level H to low level L ;

- Fig. 3B shows waveforms illustrating the variation of voltage with respect to time in various points of the circuit of Fig. 1 when the voltage is pulled up from low level L to high level H ;

- Fig. 4A shows the current variation in the output FET corresponding to the timing of Figs. 3A, 3B, comparing the circuit according to the present invention with the prior art ;

- Fig. 4B shows the variation of the time derivative of the current in the output FETs in the circuit according to the present invention and in the prior art, showing how the noise is reduced ;

- Fig. 5 shows a circuit diagram of a second embodiment of the circuit according to the present invention, wherein the resistors of the embodiment of Fig. 2 are replaced by FETs ;

- Fig. 6 shows a circuit diagram of a third embodiment of the circuit according to the present invention, wherein a time constant circuit is provided only in the gate circuit of the n channel output FET ; and

- Fig. 7 shows a circuit diagram of a fourth embodiment of the circuit according to the present invention, wherein a time constant circuit is provided only in the gate circuit of the p channel output FET.

Same or similar reference numerals designate same or corresponding parts throughout the drawings.

Fig. 2 is a circuit diagram showing a first embodiment of the output buffer circuit according to the present invention. The circuit is composed of an output CMOS inverter 7 and time constant circuits 61, 62, which drive respectively the p and n channel output FETs 71 and 72 of the CMOS inverter 7. The drains of the p channel output FET 71 and of the n channel output FET 72 are connected in common and provide the output signal to an output terminal 10. The inverter 7 is connected in series between a positive and a negative voltage source. In this embodiment, the positive source delivers a voltage of 5V whereas the negative voltage source is at the ground potential (0 volt). The output FETs 71 and 72 have large current handling capacity to supply enough current to the load (not shown).

Comparing the output CMOS circuit 7 of Fig. 2 with that of the prior art shown in Fig. 1, the gate electrodes of the CMOS transistors 71 and 72 are not connected to each other, but they are respectively driven by the time constant circuits 61 and 62, which are each encircled by a chained line. The time constant circuits comprise respective driver circuits 51, 52 whose input gate electrodes are connected in common to the input terminal 1. In this embodiment, the driver circuits 51 and 52 are inverters, which are composed of series connected p and n channel FETs 511, 512 and 521, 522, respectively. But it will be apparent for anyone skilled in the art that any kind of driver circuits, such as non inverter type driver circuits, may be used as circuits 51, 52. However, inverter type driver circuits being most commonly used in the art, the following description will be made referring only to such inverter type circuits.

In Fig. 2, inverter 51 is serially connected with a resistor R1 between a positive and a negative voltage source (5 volts and 0 volt for example). While inverter 52 is serially connected with a resistor R2, connected between the positive and negative voltage sources. As can be seen in Fig. 2, resistor R1 is connected between the source of the n channel FET 512 and the negative voltage source (0 volt), while resistor R2 is connected between the positive voltage source (5 volts) and the source of the p channel FET 521. The inverter 51 and the resistor R1 compose the time constant circuit 61, and the inverter 52 and the resistor R2 compose the other time constant circuit 62.

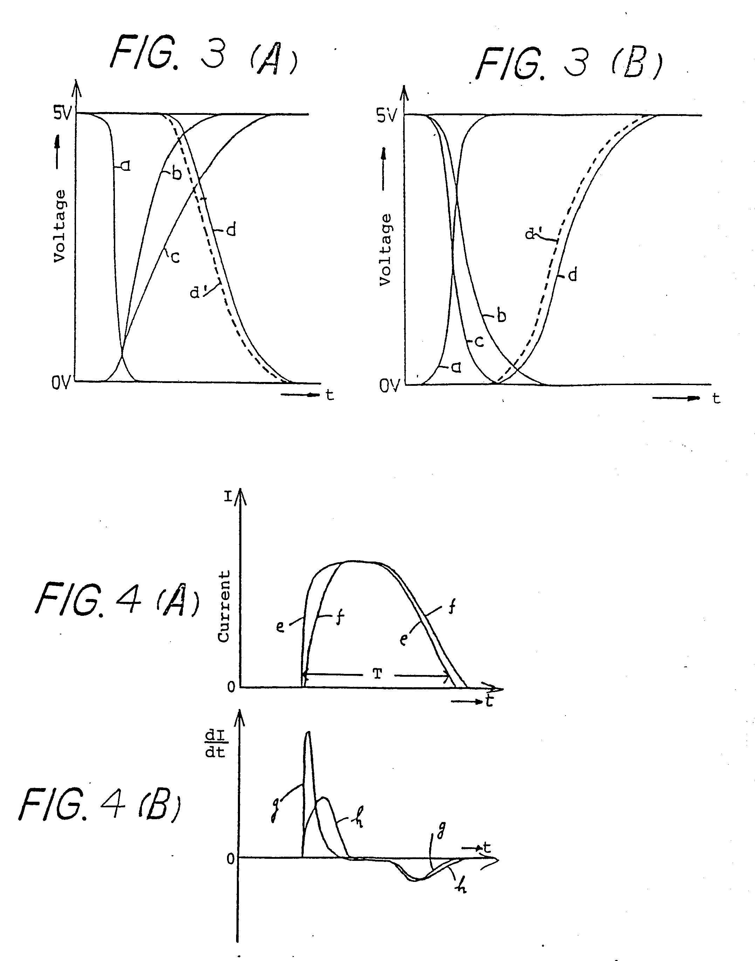

The operation and effects of the circuit will be described referring to Figs. 3A, 3B which illustrate the variation of voltage with respect to time t (abscissa) at various points of the circuit of Fig. 2.

Fig. 3A relates to the case when a signal at the input terminal 1 is switched from a high level H to a low level L. Curve a shows the variation of the voltage at circuit point a, which corresponds to the input voltage at the terminal 1 or the gate voltage for the driver circuits 51 and 52. When the gate voltage is switched from H to L, the p channel FETs 511 and 521 are turned to the ON state, and the n channel FETs 512 and 522 are turned to the OFF state. The output of driver circuits 51 and 52 varies from L to H level as shown respectively by curves b and c. It should be noted that the gate voltage of p channel FET 71, as represented by curve b, builds up faster than the gate voltage of n channel FET 72 as represented by curve c. This is due to the fact that the gate of p channel FET 71 is charged up from the positive voltage source through p channel FET 511, while the gate of n channel FET 72 is charged up from the positive voltage source through resistor R2 and p channel FET 521. Therefore, the time constant of the charge circuit for the gate of FET 71 is smaller than the one of the charge circuit for the gate of FET 72. When the gates of the output buffer circuits are switched from L to H state, p channel FET 71 is turned to the OFF state and n channel FET 72 is turned to the ON state, so that capacitive charges stored in the outer load (not shown) are discharged through n channel FET 72, and the output voltage goes down as shown by curve d.

When the output transistor (72 in the embodiment) is switched from OFF to ON, the rush current that runs through the output buffer circuit to discharge the capacitance of the outer load is very high, because the inner resistance of the buffer circuit is designed to be very low. This could provide a sharp build up of current in FET 72, and generate a noise. But, in this embodiment, the voltage variation of the gate voltage of FET 72 is slowed down as shown by curve c in Fig. 3A. Due to this slow variation, compared to prior art circuits, the rush current is suppressed, and the noise is reduced.

This is illustrated in Figs. 4A and 4B, which show the variation of currents running through the output FET 72 and their time derivative (dI/dt), with respect to time t. In Figs. 4A, 4B, the time scale in abscissa is the same as in Fig. 3A. In the absence of the time constant circuit in the input side of FET 72, the voltage build up at the gate electrode of the FET 72 is as fast as illustrated by curve b in Fig. 3A and the current running through FET 72 is as shown by curve e in Fig. 4A. Therefore, the time derivative dI/dt of the current is very large as shown by curve g in Fig. 4B, and noise is generated. But in this embodiment of the circuit according to the invention, since the variation of gate voltage of FET 72 is slowed down by the time constant circuit as shown by curve c in Fig. 3A, the current through the FET 72 is as shown by curve f in Fig. 4A. Hence, dI/dt is reduced and the noise is suppressed as shown by curve h in Fig. 4B.

It should be pointed out that even when the waveform (curve c of Fig. 3A) of the input voltage to the output buffer circuit is slowed down, the overall switching time of the circuit is not substantially increased. This is due to the fact that the overall switching time is determined by the total time to charge up or discharge the charges stored in the load capacitance through the output FET. The current flow in the output FET is determined by its gate voltage. In the absence of a time constant circuit, as in prior art circuits, the current build up in the output FET is very quick, and the current reaches quickly the value of the saturation current of the output FET as shown by curve e of Fig. 4A. Thereafter, as shown in Fig. 4A, the current remains equal to the constant saturation current until the voltage of the load capacitance starts decreasing. The current then decreases, and continues to flow until all the charges in the load capacitance are discharged. Therefore, the voltage at the output terminal goes down as shown by the broken line curve d' in Fig. 3A.

By contrast, in the circuit according to the present invention, due to the time constant circuit inserted in the gate circuit of the output FET, the build up curve of the output current is slowed down as shown by curve f of Fig. 4A. It also reaches soon the value of the saturation current and, as the discharge of the load capacitance occurs, the current goes down in a similar manner (curve f) as when no time constant circuit is provided. Therefore, the total time T to discharge the outer load capacitance is slightly longer, compared to that in the prior art circuit, but the difference is not substantial because the total discharge time is essentially determined by the saturation current and the capacitance of the outer load. Therefore, by the insertion of the time constant circuit, only the noise is reduced and the overall switching speed of the circuit is not substantially reduced.

Fig. 3B illustrates the voltage variation at the same points of the circuit of Fig. 2 when the input voltage is switched from L to H level. When the input voltage is increased from L to H as shown by curve a, the p channel FETs 511 and 521 are turned to the OFF state and the n channel FETs 512 and 522 are turned to the ON state. Then, the charges stored in the gates of the output FETs are discharged to the ground through n channel FETs 512 and 522, and the gate voltages of the FETs 71 and 72 go down respectively as shown by curves b and c. The gate voltage of p channel FET 71 (curve b) goes down slowly compared to the gate voltage of FET 72 (curve c) due to the difference in time constant caused by resistor R1. Therefore, the output voltage goes up slowly as shown by curve d compared to curve d' (illustrated by a broken line) which is the voltage variation at the output terminal of the prior art circuit. It will be clear for anyone skilled in the art that the effect regarding noise suppression and switching speed are the same as those described above.

The output buffer circuit according to the present invention has the further effect of reducing the excess current which is inherent to ordinary CMOS circuit. This will be explained referring to Figs. 3A and 3B. As mentioned before, in ordinary output buffer circuits, the gates of the p and n channel FETs are connected to each other and do not include time constant circuits. Therefore, the gate voltage of these FETs vary almost as quickly as the curve b of Fig. 3A (which shows the variation of the gate voltage of p channel FET 71). At the starting time (t=0) of the variation, the p channel FET is ON, but the n channel FET is OFF. Therefore, the current does not flow from the positive voltage source (5 volts) through the CMOS FETs to the negative voltage source (ground). But as the gate voltage goes up, the n channel FET becomes gradually conductive, and the conductivity of the p channel FET gradually decreases. Therefore, at the middle part of the curve b, both of the FETs become conductive. Accordingly, excess current runs from the positive voltage source through the CMOS FETs to the negative voltage source. When the gate voltage goes up further, the n channel FET is turned to the ON state and the p channel FET is turned to the OFF state. Therefore, the current between the positive and negative voltage sources through the CMOS is again pinched off.

The situation is similar in the case of Fig. 3B which shows the voltage variations when the input voltage is switched from L to H. In an ordinary CMOS output buffer circuits, the gate voltage of the FETs varies as shown by the curve c. For reasons similar as described above, the excess current flows from the positive voltage source through the CMOS FETs to the negative voltage source, at middle portion of the curve c.

These excess currents run every time the CMOS buffer circuit is switched from L to H and vice versa. The excess current increases as the repetition rate of switching is increased, but it does not drive the outer load. It merely increases the loss of the circuit and causes the temperature of the IC chip to rise. Such excess current is also undesirable due to the noise produced, since, as described above, it constitutes a sharp pulse current which flows at the moment when the input signal of the CMOS buffer circuit is switched from ON to OFF or vice versa.

The present invention prevents such an excess current to appear. As can be seen in Fig. 3A, when the input voltage is switched from H to L (curve a), the gate voltage of the FET 72 goes up (curve c) slower than the gate voltage of the FET 71 (curve b). As a result, when the n channel FET 72 becomes conductive, the p channel FET 71 is cut off. Similarly, as shown in Fig. 3B, when the input voltage is switched from L to H (curve a), the gate voltage of the p channel FET 71 (curve b) goes down slower than the voltage of the n channel FET 72 (curve c). Thus, before the p channel FET 71 becomes conductive, the n channel FET 72 is cut off. Therefore, the excess current is suppressed.

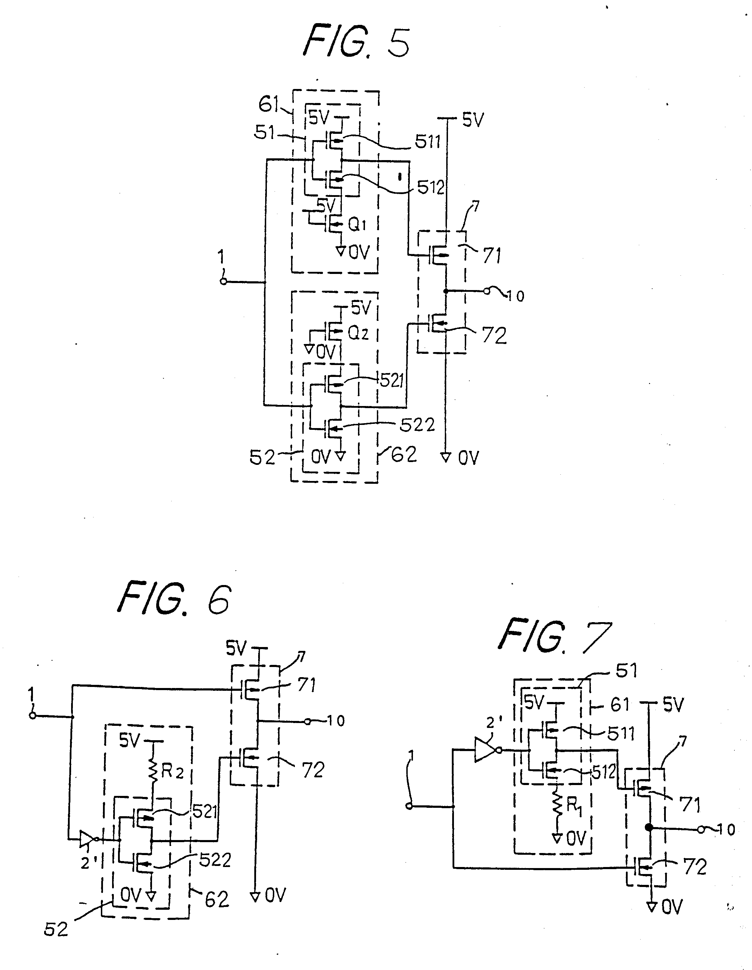

The output buffer circuit of Fig. 2 can be modified in various manners without departing from the scope of the invention. Fig. 5 shows a circuit diagram of a second embodiment of the circuit according to the present invention. Comparing the circuit of Fig. 5 with that of Fig. 2, it will be noticed that resistors R1 and R2 are replaced respectively by an n channel FET Q1 and a p channel FET Q2. The gates of FETs Q1 and Q2 are connected respectively to a positive and a negative voltage source. Accordingly, FETs Q1 and Q2 are always conductive and they can each be considered as a resistance. Therefore, resistors R1 and R2 are respectively replaced by the inner resistances of FETs Q1 and Q2.

The inner resistance of a FET is varied by changing the ratio W/L, i.e. the ratio of gate width (W) to gate length (L). It is therefore easy to design a FET having a preferred value of inner resistance. In ordinary ICs, especially in gate array type logic ICs, the IC chip is provided with many patterns of FETs having various values of W/L ratio. Therefore, it is possible to choose from these FETs, the ones having a proper internal resistance to replace resistors R1 and R2, and it is usually unnecessary to design a new FET for such purpose. The value of the resistance depends on the circuit design of the output FETs to drive the load, and how the voltage variation of the input signal is to be slowed down. By way of example, the resistance of the resistors R1 and R2 may be of a few k ohms. Further, though it is not shown in Fig. 5, FET's Q1 and Q2 may consist in a combination of many FETs connected in series or in parallel to each other to provide the preferred inner resistance value, as is well known in the technique of gate array, so that further description may be omitted for the sake of simplicity.

Fig. 6 shows a circuit diagram of a third embodiment of the circuit according to the present invention. In this embodiment, the time constant circuit 62 is provided only in the gate circuit of the n channel FET 72. As can be seen in Figs. 4A, 4B, the current variations in the output FETs are sharper when the gate voltages of the output FET are pulled up from L to H than when the gate voltages are pulled down from H to L. Therefore, the time constant circuit for the p channel output FET 71 may be eliminated. Since the inverter 51 is eliminated, the inverter 2 also becomes unnecessary. Thereby, the gate of the p channel FET 71 is connected directly to the input terminal 1, and an inverter 2' is inserted only in the gate circuit of inverter 52. It is well apparent that the operation of the circuit of Fig. 6 is similar to the one of the circuit of Fig. 2.

In the above description, the load of the output buffer circuit 7 is connected between the output terminal of the output buffer circuit 7 and a positive voltage source (as shown in Fig. 1). But it often occurs that the loads are connected between the output terminal of the buffer circuit and ground. It will be understood by anyone with ordinary skill in the art that, in such a case, the rush current flows through the p channel output FET 71 to charge up the load capacitance. In such a case, the fourth embodiment of the present invention as shown in Fig. 7 is applicable. As can be seen in Fig. 7, the time constant circuit 61 and inverter 2' are inserted only in the gate circuit of the p channel output FET 71, and the gate of the n channel output FET 72 is directly connected to the input terminal 1. The operation and effect can be easily understood by analogy with the description made with respect to the circuit of Fig. 6.

It may also be noted that the resistors in the time constant circuits may be replaced by FETs not only in the embodiment of Fig. 2, but also in the other described embodiments.

## Claims

1. Complementary metal oxide semi-conductor (CMOS) type output buffer circuit comprising :

an input terminal (1) for receiving an input signal ;

a first voltage source for providing a first voltage ;

a second voltage source for providing a second voltage ;

a p channel output field effect transistor (FET) (71) having a gate ;

an n channel output FET (72) having a gate, the p channel output FET and the n channel output FET being serially connected between the first and second voltage sources ; and

at least a first time constant circuit (61 ; 62), connected between the input terminal (1) and one of the gates of the p and n channel output FETs (71 ; 72), for slowing down the voltage rise up or falling down of a signal appearing at said one of the gates of the p and n channel output FETs in response to the input signal ;

the other one of the gates of the p and n channel output FETs (71 ; 72) being operatively connected to the input terminal (1).

2. A CMOS output buffer circuit according to claim 1, characterized in that it further comprises a second time constant circuit (61 ; 62), connected between the input terminal (1) and the other one of the gates of the p and n channel output FETs (71; 72).

3. CMOS output buffer circuit according to claim 1, characterized in that the first time constant circuit (61) is connected between the input terminal (1) and the gate of the p channel output FET (71).

4. CMOS output buffer circuit according to claim 1, characterized in that the first time constant circuit (62) is connected between the input terminal (1) and the gate of the n channel output FET (72).

5. CMOS output buffer circuit according to anyone of claims 1 to 4, characterized in that the first time constant circuit (61, 62) comprises a driver circuit for driving said one channel output FET and a resistor (R1, R2) connected in series between said driver circuit and one of the first and second voltage sources.

6. CMOS output buffer circuit according to claim 3, characterized in that the first time constant circuit (61) comprises a driver for driving the p channel output FET (71) and a resistor (R1) connected in series between the driver circuit and the second voltage source.

7. CMOS output buffer circuit according to claim 4, characterized in that the first time constant circuit (62) comprises a driver for driving the n channel output FET (72) and a resistor (R2) connected in series between the driver circuit and the first voltage source.

8. CMOS output buffer circuit according to claim 2, characterized in that the first time constant circuit (61) is connected to the gate of the p channel output FET (71) and comprises a driver circuit for driving the p channel output FET and a resistor (R1) connected in series between the driver circuit and the second voltage source ; and

the second time constant circuit (62) is connected to the gate of the n channel output FET (72) and comprises a driver circuit for driving the n channel output FET and a resistor (R2) connected in series between the driver circuit and the first voltage source.

9. CMOS output buffer circuit according to claim 2, characterized in that the first time constant circuit (61) is connected to the gate of the p channel output FET (71) and comprises a driver circuit for driving the p channel output FET and an n channel FET (Q1) connected in series between the driver circuit and the second voltage source, the gate of said n channel FET (Q1) being connected to the first voltage source ; and

the second time constant circuit (62) is connected to the gate of the n channel output FET (72) and comprises a driver circuit for driving the n channel output FET and a p channel output FET (Q2) connected in series between the driver circuit and the first voltage source, the gate of the p channel FET (Q2) being connected to the second voltage source.

10. CMOS output buffer circuit according to anyone of claims 5 to 9, characterized in that the driver circuit is an inverter composed of serially connected p channel FET and n channel FET.

11. CMOS output buffer circuit according to claim 10, characterized in that the p and n channel output FETs have a lower internal resistance than the one of the p and n channel FETs in the inverter.

12. Complementary metal oxide semi-conductor (CMOS) type output buffer circuit, characterized in that it comprises :

an input terminal (1) for receiving control signals ;

an output terminal (10) for providing output signals ;

a first voltage source for providing a first voltage ;

a second voltage source for providing a second voltage ;

a p channel output field effect transistor (FET) (71) having a low internal resistance, the source of said p channel output FET being connected to the first voltage source ;

an n channel output FET (72) having a low internal resistance, the drain of said n channel output FET (72) being connected to the drain of said p channel output FET (71) and to said output terminal (10), and the source of said n channel output FET (72) being connected to the second voltage source ;

a first time constant circuit (61) connected to the gate of the p channel output FET (71), and comprising an inverter circuit (51) composed of serially connected p channel (FET) 511) and n channel FET (512), for driving the gate of said p channel output FET (71) ; and a resistor (R1) connected between the source of the n channel FET (512) and the second voltage source ; and      a second time constant circuit (62) connected to the gate of the n channel output FET (72), and comprising an inverter circuit (52) composed of serially connected p channel FET (521) and n channel FET (522), for driving said n channel output FET (72) ; and a resistor (R2) connected between the source of the p channel FET (521) and the first voltage source ;

the gates of said p channel FETs (511, 521) and n channel FETs (512, 522) of said inverters being connected in common to the input terminal (1).

13. Complementary metal oxide semi-conductor (CMOS) type output buffer circuit, characterized in that it comprises :

an input terminal (1) for receiving control signals ;

an output terminal (10) for providing output signals ;

a first voltage source for providing a first voltage ;

a second voltage source for providing a second voltage ;

a p channel output field effect transistor (FET) (71) having a low internal resistance, the gate and source of which being connected respectively to the input terminal (1) and to the first voltage source ;

an n channel output FET (72) having a low internal resistance, the drain of which being connected to the drain of said p channel output FET (71) and to the output terminal (10), and the source of the n channel output FET (72) being connected to the second voltage source ;

a time constant circuit (62) connected to the gate of the n channel output FET (72), and comprising an inverter circuit (52) composed of serially connected p channel FET (521) and n channel FET (522), for driving the gate of said n channel output FET (72), and a resistor (R2) connected between the source of the p channel FET (521) and the first voltage source ; and

a second inverter (2') having an input connected to the input terminal (1), and an output connected in common to the gates of the p channel FET (521) and n channel FET (522) of said inverter circuit (52).

14. Complementary metal oxide semi-conductor (CMOS) type output buffer circuit, characterized in that it comprises :

an input terminal (1) for receiving control signals ;

an output terminal (10) for providing output signals ;

a first voltage source for providing a first voltage ;

a second voltage source for providing a second voltage ;

a p channel output field effect transistor (FET) (71) having a low internal resistance, the source of which being connected to said first voltage source ;

an n channel output FET (72) having a low internal resistance, the drain of which being connected to the drain of the p channel output FET (71), and to the output terminal (10), and the source of the n channel output FET (72) being connected to the second voltage source ;

a time constant circuit (61) connected to the gate of the n channel output FET (71), and comprising the inverter circuit (51) composed of serially connected p channel output FET (71), and a resistor (R1) connected between the source of the n channel FET (512) of the inverter circuit (51) and the second voltage source ; and

a second inverter (2') having an input connected to the input terminal (1), and an output connected in common to the gates of the p channel FET (511) and n channel FET (512) of said inverter circuit (51).

15. CMOS output buffer circuit according to anyone of claims 12, 13 and 14, characterized in that said resistors (R1, R2) are respectively formed by the internal resistance of an n channel FET (Q1) and a p channel FET (Q2), the gates of which are respectively connected to one of the first or second voltage sources.

0251910

## FIG. 2

## FIG. 1     PRIOR ART

FIG. 3 (A)

FIG. 3 (B)

FIG. 4 (A)

FIG. 4 (B)

0251910

0251910

## FIG. 5

## FIG. 6

## FIG. 7